# EUROPEAN PATENT APPLICATION

(11) **EP 1 467 492 A1**
(43) Date of publication of application: **13.10.2004**
(21) Application number: 04251712.8
(22) Date of filing: 24.03.2004
(51) Int. Cl.: H03M 13/29

(54) **Iterative decoding of a concatenated convolutional and block encoded signal**

(30) Priority: 27.03.2003 GB 0307092
(71) Applicant: Tandberg Television ASA, 1326 Lysaker (NO)
(72) Inventor: Huggett, Anthony Richard, Eastleigh, Hampshire SO50 5PZ (GB)
(74) Representative: Molyneaux, Martyn William

(57) **Abstract**

A concatenated convolutional encoded and block encoded signal is decoded conventionally using a first Viterbi decoder (22), a de-interleaver (23) and a block decoder (such as a Reed-Solomon decoder). Blocks correctly decoded by the block decoder are identified by the block decoder and marked in an output signal from the block decoder. The marked decoded signal is interleaved (26) to form an interleaved marked decoded signal. A delayed version of the encoded signal (21') is decoded with a second Viterbi decoder (32), using the known bits from the marked decoded signal. That is, states of the encoder with which the encoded signal was encoded which are inconsistent with known bits from known blocks are discounted in the second Viterbi decoding, as are any transitions passing through such a state. This may be visualised as constraining a Viterbi trellis in the vicinity of the known bits. Output from the second Viterbi decoder may be de-interleaved (33) and block decoded (34) to form a decoded output. Further iterations of the decoding with further delayed versions of the encoded signal and further de-interleaving and block decoding stages may be performed until no significant further improvement in the error rate of the decoded signal is achieved.

## Description

This invention relates to decoding a concatenated convolutional and block encoded signal or data stream.

Many known forward error correction (FEC) schemes, for example, Digital Video Broadcasting - Satellite (DVB(S)), Digital Video Broadcasting - Terrestrial (DVB(T)), Broadband Wireless Internet Forum (BWIF) and Digital Satellite System (DSS), consist of an outer Reed Solomon code together with an inner convolutional code.

Typically a decoder for such a FEC scheme consists of a Viterbi decoder for the inner convolutional code, a de-interleaver and a Reed Solomon decoder. Following decoding by the Reed Solomon decoder, some of information bits are known to be correct. However, no use is made of the fact that some information bits are known to be error free in improving the effectiveness of the decoder.

It is an object of the present invention at least to provide an improved decoder for these schemes over the prior art.

According to a first aspect of the invention, there is provided a method of decoding a concatenated convolutional encoded and block encodedsignal, the method comprising the steps of (a) applying the encoded signal to first Viterbi decoder means and delay means to form a delayed encoded signal; (b) decoding the encoded signal with the first Viterbi decoder means to form a first Viterbi decoded signal; (c) de-interleaving the first Viterbi decoded signal with first de-interleaver means to form a first de-interleaved signal; (d) block decoding the first de-interleaved signal, with first block decoder means, identifying correctly decoded blocks and marking decoded bits identified as belonging to the correctly decoded blocks to form a marked decoded signal; (e) interleaving the marked decoded signal using first interleaver means for output to second Viterbi decoder means; (f) decoding the delayed encoded signal with the second Viterbi decoder means using the interleaved marked decoded signal by: for each received encoded symbol representative of a bit in an original signal encoded with a convolutional encoder and block encoder to form the concatenated convolutional encoded and block encoded signal, adding, for each possible current state of the convolutional encoder, error coefficients representative of differences between the received encoded symbol, representative of a transition from a previous state to a current state, and expected symbols corresponding to predetermined permitted transitions from previous states to the current state, to a sum of such error coefficients for said previous states to form updated sums of such error coefficients for each of a new plurality of state sequences for all possible states; determining whether the bit is a marked dioded bit and if the bit is a marked decoded bit, for every state, selecting both a most probable state sequence ending in that state from the new plurality of state sequences and a corresponding updated sum of error coefficients according to said predetermined bit, thereby discounting, at a bit location in the encoded signal corresponding to the marked decoded bit, any state inconsistent with the marked decoded bit; if the bit is not a marked decoded bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences; determining a best current state for the bit in the original signal by one of comparing the updated sums of error coefficients of the most probable state sequences for every state and choosing a state arbitrarily; and thereby determining, by tracing back from the best current state, a most probable earliest transition and earliest state that occurred a predetermined plurality of symbols previously, and outputting a bit most probably equal to the bit in the original signal to form a second Viterbi decoded signal; (g) de-interleaving the second Viterbi decoded signal with second de-interleaver means to form a second de-interleaved signal; and (h) block decoding the second de-interleaved signal with second block decoder means to form a decoded output signal.

Conveniently the method includes further iterative steps of using further delay means further to delay the delayed encoded signal and repeating at least once the steps of decoding the delayed encoded signal to decode the further delayed encoded signal using known bits from the decoded output signal.

Conveniently, the step of decoding the delayed encoded signal comprises determining a Viterbi state trellis corresponding to a convolutional code used to encode the encoded signal, adding and comparing error coefficients of transition paths of the delayed encoded signal through the Viterbi state trellis to select a most probable transition path, while ignoring at a location in the delayed encoded signal corresponding to the marked decoded bits in the marked decoded signal any state in the Viterbi state trellis not consistent with the marked decoded bits and any transition path passing through such a state, thereby determining, from the most probable transition path, a second Viterbi decoded signal having a least number of errors taking into account the marked decoded bits in the marked decoded signal.

Advantageously, the step of block decoding comprises Reed-Solomon block decoding.

Conveniently, wherein the original signal has at least one predetermined bit at a predetermined bit location, and the step of decoding the encoded signal with the first Viterbi decoder means comprises: (a) for each received encoded symbol of the encoded signal representative of a bit in the original signal, adding, for each possible current state, error coefficients representative of differences between the received encoded symbol, representative of a transition from a previous state of the convolutional encoder to a current state, and expected symbols corresponding to predetermined permitted transitions from previous states to the current state, to a sum of such error coefficients for said previous states to form updated sums of such error coefficients for each of a new plurality of state sequences for all possible states; (b) if the bit is a predetermined bit, for every state, selecting both a most probable state sequence ending in that state from the new plurality of state sequences and a corresponding updated sum of error coefficients according to said predetermined bit, thereby discounting, at the bit location in the encoded signal corresponding to the predetermined bit location in the original signal, any state inconsistent with the predetermined bit at the predetermined bit location; (c) if the bit is not a predetermined bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences; (d) determining a best current state for the bit in the original signal by either comparing the updated sums of error coefficients of the most probable state sequences for every state or choosing a state arbitrarily; and (e) thereby determining, by tracing back from the best current state, a most probable earliest transition and earliest state that occurred a predetermined plurality of symbols previously, and thereby finding and outputting a bit most probably equal to the bit in the original signal.

Conveniently, the step of adding sums of error coefficients comprises the steps of: determining a Viterbi state trellis corresponding to a convolutional code used to encode the encoded signal; and adding sums of error coefficients of transition paths of the encoded signal through the Viterbi state trellis to select a most probable transition path.

Advantageously, the at least one predetermined bit at a predetermined bit location is a synchronisation bit.

According to a second aspect of the invention, there is provided a decoder for decoding a concatenated convolutional encoded and block encoded signal derived from an original signal, comprising: receiving means for receiving the encoded signal; applying means connected to the receiving means and to first Viterbi decoder means and first delay means for applying the encoded signal thereto; first de-interleaver means connected to the first Viterbi decoder means for de-interleaving a decoded signal received from the first Viterbi decoder means to form a first de-interleaved signal; first block decoder means connected to the first de-interleaver means for block decoding the first de-interleaved signal, identifying correctly decoded blocks and marking decoded bits identified as belonging to the correctly decoded blocks to form a marked decoded signal; first interleaver means connected to the first block decoder means for interleaving the marked decoded signal; second Viterbi decoder means connected to the first interleaver means and to the first delay means for decoding a delayed encoded signal received from the first delay means using the marked decoded signal by: for each received encoded symbol of the delayed encoded signal representative of a bit in the original signal, adding, for each possible current state of a convolutional encoder used to encode the convolutional encoded and block encoded signal, error coefficients representative of differences between the received encoded symbol, representative of a transition from a previous state of the encoder to a current state, and expected symbols corresponding to predetermined permitted transitions from previous states to the current state, to a sum of such error coefficients for said previous states to form updated sums of such error coefficients for each of a new plurality of state sequences for all possible states; if the bit is a marked decoded bit, for every state, selecting both a most probable state sequence ending in that state from the new plurality of state sequences and a corresponding updated sum of error coefficients according to said predetermined bit, thereby discounting, at a bit location in the encoded signal corresponding to the marked decoded bit, any state inconsistent with the marked decoded bit; if the bit is not a marked decoded bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences; determining a best current state for the bit in the original signal by one of comparing the updated sums of error coefficients of the most probable state sequences for every state and choosing a state arbitrarily; and thereby determining, by tracing back from the best current state, a most probable earliest transition and earliest state that occurred a predetermined plurality of symbols previously, and outputting a bit most probably equal to the bit in the original signal; second de-interleaver means connected to the second Viterbi decoder means for de-interleaving a signal received from the second Viterbi decoder means to form a second de-interleaved signal; second block decoder means connected to the second de-interleaver means for block decoding the second de-interleaved signal to form a decoded output signal; and transmitting means connected to the second block decoder means for transmitting the decoded output signal.

Conveniently, the decoder comprises second delay means, and second interleaver means, third Viterbi decoder means, third de-interleaver means and third block decoder means for carrying out one or more decoding iterations to decode a further delayed encoded signal from the second delay means using known bits of the decoded output signal from a previous iteration.

Advantageously, the second Viterbi decoder means is arranged to determine a Viterbi state trellis corresponding to a convolutional code used to encode the encoded signal, to add and compare error coefficients of transition paths of the delayed encoded signal through the Viterbi state trellis to select a most probable transition path, while ignoring at a location in the delayed encoded signal corresponding to the marked decoded bits in the marked decoded signal any state in the Viterbi state trellis not consistent with the marked decoded bits and any transition path passing through such a state, thereby to determine, from the most probable transition path, a second Viterbi decoded signal having a least number of errors taking into account the marked decoded bits in the marked decoded signal.

Preferably, each of the block decoding means comprises Reed-Solomon block decoding means.

Conveniently, where the decoder is for decoding an encoded signal having at least one predetermined bit at a predetermined bit location, the first Viterbi decoder means comprises: summing means for adding for each received encoded symbol representative of a bit in the original signal, and for each possible current state, error coefficients representative of differences between the received encoded symbol, supposedly representative of a transition from a previous state of the encoder to a current state, and expected symbols corresponding to predetermined alternative permitted transitions from previous states to the current state, to a sum of such error coefficients for said previous states to form updated sums of such error coefficients for each of a new plurality of state sequences for all possible states, comparing and selecting means for: if the bit is a predetermined bit, for every state, selecting both a most probable state sequence ending in that state from the new plurality of state sequences and a corresponding updated sum of error coefficients according to said predetermined bit, thereby discounting, at a bit location in the encoded signal corresponding to the predetermined bit location in the original signal, any state inconsistent with the predetermined bit at the predetermined bit location; and, if the bit is not a predetermined bit, for every state comparing said updated sums of error coefficients and selecting an updated sum of error coefficients representing a lesser total of said differences between the received encoded symbols and the expected symbols and selecting a corresponding most probable state sequence ending in that state from the new plurality of state sequences; and processing means for determining a best current state for the bit in the original signal by either comparing the updated sums of error coefficients of the most probable state sequences for every state or choosing a state arbitrarily; and thereby determining, by tracing back from the best current state, a most probable earliest transition and earliest state that occurred a predetermined plurality of symbols previously, and thereby finding a bit most probably equal to the bit in the original signal.

Conveniently, the first Viterbi decoder means is arranged to: determine a Viterbi state trellis corresponding to a convolutional code used to encode the encoded signal; and add sums of error coefficients of transition paths of the encoded signal through the Viterbi state trellis to select a most probable transition path.

Advantageously, the at least one predetermined bit at a predetermined bit location is a synchronisation bit.

According to a third aspect of the invention, there is provided a computer program comprising code means for performing all the steps of the method described above when the program is run on one or more computers.

The invention will now be described, by way of example, with reference to the drawings in which:
Figure 1 is a schematic diagram of a concatenated convolutional and block encoding process according to the prior art;
Figure 2 is a schematic diagram of a concatenated convolutional and block decoding process according to the prior art;
Figure 3 is a schematic diagram of a concatenated convolutional and block decoding process according to the present invention;
Figure 4 is a known state Viterbi decoder trellis;
Figure 5 is a state Viterbi decoder trellis modified by a known information bit, useful in understanding the invention;
Figure 6 is a graph of Packet Error Rate (PER) as ordinates vs. signal to noise ratio as abscissae comparing error rates of the prior art with error rates achieved according to the invention with a DVB(S) 1/2 rate convolutional encoder;
Figure 7 is a graph of PER as ordinates vs. signal to noise ratio as abscissae comparing error rates of the prior art with simulated error rates achieved according to the invention with a DVB 2/3 rate convolutional encoder;
Figure 8 is a flowchart of an add, compare and select procedure used in Viterbi decoding in the prior art; and
Figure 9 is a flowchart of the add, compare and select procedure of Figure 8 modified according to the invention.

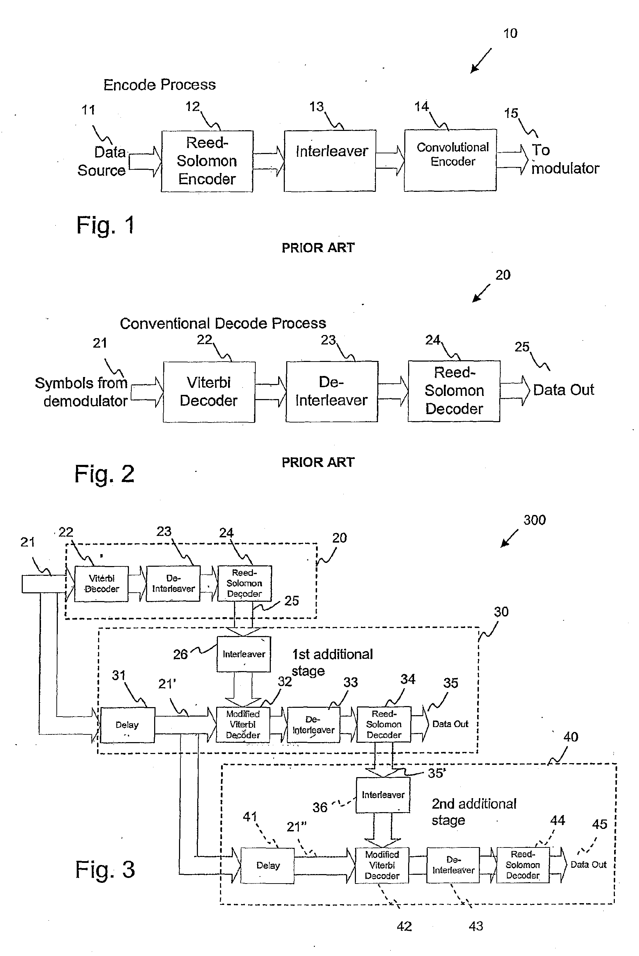

A known concatenated convolutional and block encoder process 10 is shown in Figure 1, in which a data stream from a data source 11 is input to a Reed-Solomon encoder 12, a block encoded data stream from the Reed-Solomon encoder 12 is output to an interleaver 13, an interleaved block encoded data stream is output from the interleaver 13 to a convolutional encoder 14 which outputs a concatenated convolutional and block encoded data stream to a modulator 15.

Similarly a known concatenated convolutional and block decoder process 20 is shown in Figure 2, in which a concatenated convolutional and block encoded data stream 21 from a demodulator is input to a Viterbi decoder 22, which outputs an interleaved block encoded data stream to a de-interleaver 23, a block encoded data stream is output by the de-interleaver 23 to a Reed-Solomon decoder 24 which outputs a decoded data stream 25.

A concatenated convolutional and block decoder process 300 according to the invention, shown in Figure 3, may also have a known initial stage 20 in which a concatenated convolutional and block encoded data stream 21 from a demodulator is input to the Viterbi decoder 22, which outputs an interleaved block encoded data stream to the de-interleaver 23, and a block encoded data stream is output from the de-interleaver 23 to the Reed-Solomon decoder 24 which outputs a decoded data stream 25. However, in an additional stage 30 in the decoding process 300 of the invention, the decoded data stream 25 is interleaved by a first interleaver 26 and the interleaved data stream is input to a first modified Viterbi decoder 32 (described hereinafter) arranged to decode the concatenated convolutional and block encoded data stream 21' delayed by a first delay 31. The modified Viterbi decoder 32 outputs an interleaved block encoded data stream to a second de-interleaver 33, a block encoded data stream is output from the second de-interleaver 33 to a second Reed-Solomon decoder 34 which outputs a decoded data stream 35.

In an optional further additional stage 40, the decoded data stream 35' is interleaved by a second interleaver 36 and the interleaved data stream is input to a second modified Viterbi decoder 42, arranged to decode the concatenated convolutional and block encoded data stream 21 " delayed by a series of the first delay 31 and a second delay 41. The second modified Viterbi decoder 42 outputs an interleaved block encoded data stream to a third de-interleaver 43, a block encoded data stream is output by the third de-interleaver 43 to a third Reed-Solomon decoder 44 which outputs a decoded data stream 45.

Optionally, further additional stages, similar to additional stage 40, may be added.

Describing the process 300 of the invention in more detail, encoded symbols 21 are presented to the conventional concatenated decoder 20, comprising in sequence the Viterbi decoder 22, the de-interleaver 23 and the Reed Solomon decoder 24. The symbols are also presented to the delay chain 31, 41. Where an output packet of the conventional decoder 20 is indicated as being a valid codeword by the Reed Solomon decoder 24, the bytes in this packet are marked as being correct to provide a marked decoded signal. These bytes that are known to be correct are then used after interleaving and serialisation as known bits input to a second stage of decoding operating on the delayed channel information 21' and incorporating a modified Viterbi algorithm as described below. This process can be extended to further iterations as required.

By means of a modification to the Viterbi decoder, as described below, it is possible to constrain the modified Viterbi decoder to make use of information bits which are known to be correct, i.e. known bits, when the corresponding symbols are presented to the modified Viterbi decoder. This not only results in the correct decoding of the known bits, but an improvement is seen in the decoding of bits near to the known bits which may be visualised as due to constraining, in the vicinity of the known bit, a Viterbi decoding trellis associated with the modified Viterbi decoder.

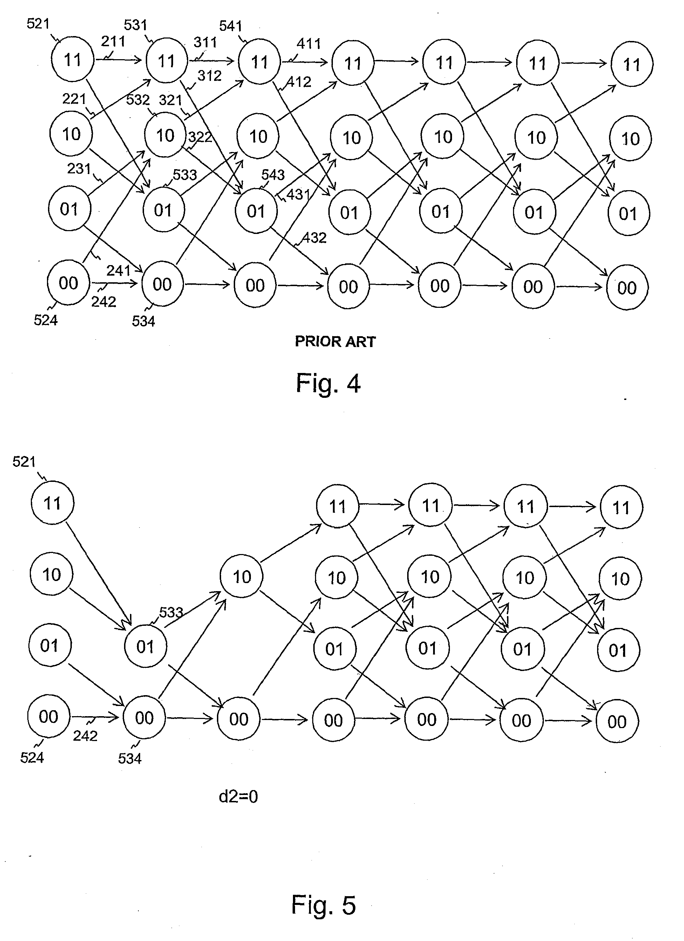

Figure 4 shows a known Viterbi decoding trellis of allowed states and transitions between the states for a 1/2 rate convolutional coder of constraint length 3, having allowed states d1d2 = 11,10,01,00, to aid visualisation of the Viterbi decoding process.

The Viterbi decoder operates iteratively as follows. At every time instant each state has a pointer to the previous state in the best sequence of states, or path, that finishes in this state. It follows that there are as many paths as there are states. Each state also has an associated path metric which represents the probability of all the received symbols up to the current one assuming that the encoder passed through the most probable path that finishes in that state. By Bayes' rule this is equivalent to the probability of the best path finishing in this state given all the received symbols, multiplied by some constants which are hard to calculate (and which may be ignored). It is convenient (and usual practice) to use a logarithmic number representation, thus multiplication of probabilities is replaced by addition of metrics.

At a next time instant, i.e. when a new symbol is received, a new set of path metrics are calculated, one for each state, using an Add-Compare-Select (ACS) operation. For each new state the ACS operation generates a result for each of the two possible previous states by adding the metric associated with that state to a score which depends on the received symbol and the expected symbol given the transition from that previous state to the new state. The ACS operation then compares these results and selects the best, storing the result of this decision as the last transition in the best path to this state, as well as the new metric. Once all the new metrics have been calculated the old metrics no longer need to be stored, and the next received symbol can be processed. This means that for every symbol the ACS operation has to be performed to compute the path metric to every state and to decide which is the best previous state in the best path to that state.

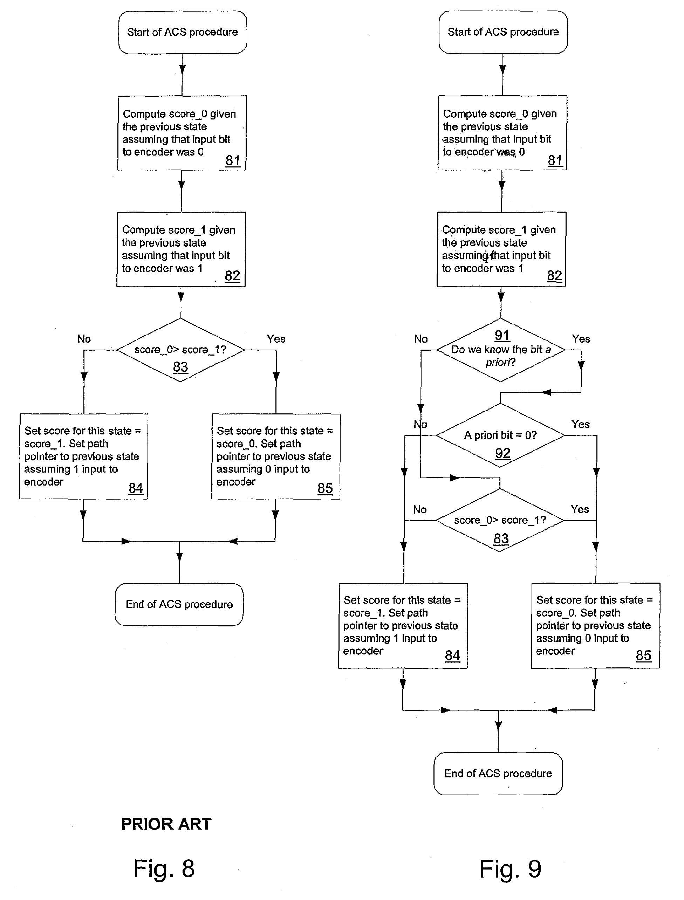

This ACS procedure is illustrated in the flowchart of Figure 8. On receipt of a symbol, a score_0 is calculated, step 81, by adding the path metric for the unique previous state which is consistent with the assumption that the corresponding input bit to the encoder was 0, to an error coefficient score based on a negative squared Euclidean distance between the received symbol and the expected symbol given the supposed previous state. A score_1 is also calculated, step 82, in an identical manner assuming that the corresponding input bit to the encoder was 1. The two scores are compared, step 83, and if score_1 is greater than score_0, the score for the state is set, step 84, to score _1 and a transition path to the previous state is set assuming the original input bit was 1. If, on the other hand, score_0 is greater than score_1, the score for the state is set, step 85, to score_0 and the transition path to the previous state is set assuming the original input bit was 0. It is the nature of the algorithm that if the paths are traced back far enough, all of the paths will have converged to the same state. To determine the output bit from the Viterbi decoder associated with a particular symbol it is necessary to wait until many more symbols have been processed and then to look back at the trellis to see the converged path. The decoded bits may then be simply determined as the transitions along this path.

For a real decoder it is necessary to impose a finite limit on the length of the trace back; typically a number of symbols between 5 and 10 times the constraint length are received before determining the state and hence the output bit. Most commonly this is done by choosing a best state, and tracing back as far as the path memory will allow to find the first transition in that path. Preferentially the best state is the state with the best score, but it may be an arbitrary state (e.g. all 0's) for simplicity. For continuous operation this trace back operation to the earliest transition in the best path is performed once for every input symbol.

The decoder algorithm may be started either in a known state or with all states equiprobable.

Where some input bits are known the selection operation is overridden using such fixed bit information; that is the best previous state is chosen taking account of the fixed bit. The score for this state is set corresponding to this decision. In a preferred implementation the fixed bit (for a non-recursive code) is chosen as the final bit in the previous state (i.e. d2 in the example below).

The modified ACS procedure according to the invention is illustrated in Figure 9. Having computed, steps 81 and 82, score_0 and score_1 as in the unmodified ACS procedure it is determined, step 91, whether the original bit is a fixed bit. If the original bit is not a fixed bit, then the procedure continues as in the unmodified ACS procedure of comparing, step 83, the two scores and setting, steps 84, 85, the state and transition path accordingly. If, however, it is determined, step 91, that the original bit is a fixed bit, it is determined, step 92, whether the fixed bit is a 0 or 1. If the fixed bit is 1, the score for the state is set, step 84, to score_1 and a transition path to the previous state is set knowing the original input bit was 1. If, on the other hand, the fixed bit is 0, the score for the state is set, step 85, to score_0 and the transition path to the previous state is set knowing the original input bit was 0.

By way of example, consider that it is known that after the second transition d2=0 as shown in Figure 5. Then, referring to Figures 4 and 5, it is known that the states 541, 543 equal to 11 (i.e. d1=1,d2=1) and 01 (i.e. d1=0, d2=1) respectively in the third column of the trellis (after time step 2) cannot be valid, since they have d2=1, so that those states and any transactions leading to them 311,321; 312,322 or from them 411,412; 431,432 may effectively be removed or discounted when comparing paths through the trellis. Similarly, states 531, 532, equal to 11 and 10 in the second column (after time step 1) in the example illustrated, which no longer have any transitions leading from them, may also be effectively removed or discounted, together with any transactions 211,221; 231,241 leading to them, thereby reducing a number of paths through the trellis which need to be compared, and increasing the confidence with which adjoining bits may be decoded.

In practice, the effect of the fixed bit override is on the ACS module itself. The implications for a search through the trellis follow automatically from the behaviour of the Viterbi algorithm ― it is not necessary actually to remove or discount states - indeed it would be computationally expensive to do so.

Referring to Figures 4 and 5, states 543 equal to 01 and 541 equal to 11 are removed from consideration after time step 2 simply by constraining the decisions made at each of the four states after time step 3. It follows that the Viterbi algorithm itself will remove paths through states 531 and 532 - it is not necessary to engage in expensive trellis pruning operations.

Referring again to Figure 3, the output 25 of a conventional decoder 20 is a series of packets. Some of these packets will be marked as being erroneous by the Reed-Solomon decoder 24; the others will have been decoded correctly and can be regarded as being correct. In the case of DVB(S), a packet cannot be correctly decoded by the Reed-Solomon decoder if the packet contains nine or more byte errors. Packets with eight or fewer errors are always decoded correctly.

The interleaver 26 also interleaves a signal generated by the Reed-Solomon decoder 24 that marks whether or not a packet is correct. The result is an interleaved series of bytes together with a signal that marks whether or not the byte belongs to a correctly decoded packet.

The data is then serialised and the serialised data is passed to the modified Viterbi decoder 32. When the serialised data comes from a correctly decoded packet this allows the Viterbi decoder 32 to fix its decisions according to the known input bit, otherwise the normal add-compare-select function is used.

Provided that a significant fraction of the packets is correctly decoded by the first Reed-Solomon decoder 24, the output from the first modified Viterbi decoder 32 should be much better than the output of the first Viterbi decoder 22 and indeed better than the first Reed-Solomon decoder output 25. If the first modified Viterbi decoder 32 has succeeded in decoding a few more bytes correctly in positions where there were erroneous bytes within the erroneous packets after the first iteration, the second Reed-Solomon decoder 34 will be able to decode the packet if the packet now contains eight or fewer errors.

Furthermore, continuing to refer to Figure 3, where known information can be identified in the symbol stream 21 prior to the first stage of decoding 20 e.g. there is a repeating synchronisation byte pattern, a modified Viterbi decoder may also be used in the first stage 20, instead of the Viterbi decoder 22, using the repeating synchronisation bits as known bits.

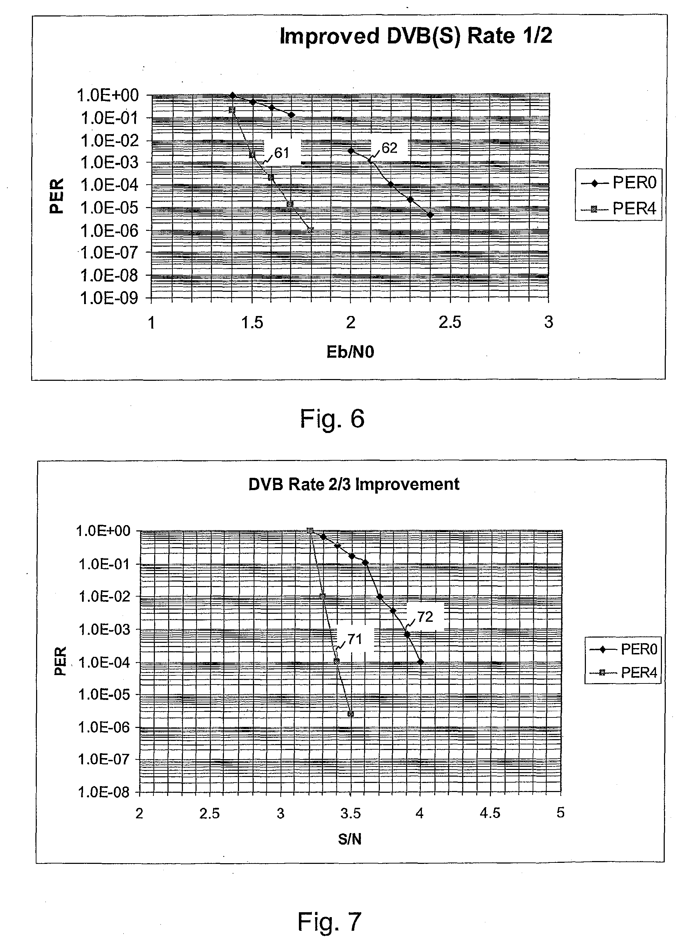

The graph of Figure 6 shows a plot 61 of packet error rate (PER) vs. signal to noise ratio for a DVB(S) rate ½ decoder using four additional iterations (PER4) compared with a plot 62 for a decoder having no extra iterations (PER0) i.e. a conventional DVB decoder. If the plots 61, 62 were extrapolated through 1E-7, the point at which errors start to become significant in customer tests, it can seen that the gain of the method would be some 0.8 dB. However a recommended operating point of DVB(S) is 3.33 dB, giving the method of the invention a gain of 1.0dB at the same PER by extrapolation of the plots 61, 62.

Figure 7 showing simulation results for DVB(S) Rate 2/3, indicates a similar improvement between a plot 71 achievable with the invention using four iterations compared with a prior art plot 72 using no additional stages. The recommended operating point for a conventional decoder is 5.0 dB S/N, which would again, by extrapolation, suggest a gain of around 1.0 dB with the invention. At this point the PER would, by extrapolation, be near 1E-15.

There are several reasons why the decoding process of the invention provides better error correction results than the known decoding process:
i) No errors are made in any of the bits that are already known.
ii) The trellis is constrained so that the starting and ending points are known. This limits the freedom of the decoder to make certain wrong choices.
iii) Bursts of errors cannot propagate across known bytes (since the length of a byte is greater than the memory of the convolutional encoder).
iv) The noisiest symbols in the signal which may cause a burst of errors to occur in the first iteration do not necessarily coincide with an erroneous packet at the input to the Viterbi decoder in the second iteration.

Multiple iterations are useful provided that every iteration corrects at least one extra erroneous packet within a burst of erroneous packets. This criterion might provide a useful early limiting criterion for the number of iterations for certain implementations. However, extra iterations can never degrade the PER performance,

Although the algorithm has been described in terms of a number of identical stages 30, 40 there are some optimizations which can be made. Since bursts of errors cannot propagate across a known byte there is no benefit in having a long look-back depth in later stages of a multistage Viterbi decoder. Only results looking back from the start of a new section of known states to the previous section of known states are of interest. With a Reed Solomon decoder operating on bytes (8 bits) and a convolutional encoder memory depth of 6 bits, with one consecutive erroneous packet there are only 14 unknown states (and some of these are not completely free). With two consecutive erroneous packets there will be 22 unknown states, etc. This means that the read-back length of the modified Viterbi decoder may be greatly reduced for later iterations for very little performance penalty.

This invention provides an improvement over the performance of a conventional decoder for a concatenated scheme by using the modified Viterbi algorithm described above. This improvement does not require any changes in the encoder nor its mode of operation.

Other FEC schemes such as Digital Video broadcasting (DVB), Digital Satellite News Gathering (DSNG) and 8-level Vestigial Sideband (8VSB) have an inner trellis code which may also benefit from this invention.

## Claims

1. A method of decoding a concatenated convolutional encoded and block encoded signal, the method comprising the steps of:
a) applying the encoded signal (21) to first Viterbi decoder means (22) and delay means to form a delayed encoded signal (21);
b) decoding the encoded signal (21) with the first Viterbi decoder means to form a first Viterbi decoded signal;
c) de-interleaving the first Viterbi decoded signal with first de-interleaver means (23) to form a first de-interleaved signal;
d) block decoding the first de-interleaved signal, with first block decoder means (24), identifying correctly decoded blocks and marking decoded bits identified as belonging to the correctly decoded blocks to form a marked decoded signal (25);
e) interleaving the marked decoded signal using first interleaver means (26) for output to second Viterbi decoder means (32);
f) decoding the delayed encoded signal with the second Viterbi decoder means using the interleaved marked decoded signal by: for each received encoded symbol representative of a bit in an original signal encoded with a convolutional encoder and block encoder to form the concatenated convolutional encoded and block encoded signal, adding (81. 82), for each possible current state of the convolutional encoder, error coefficients representative of differences between the received encoded symbol, representative of a transition from a previous state to a current state, and expected symbols corresponding to predetermined permitted transitions from previous states to the current state, to a sum of such error coefficients for said previous states to form updated sums of such error coefficients for each of a new plurality of state sequences for all possible states; determining (91) whether the bit is a marked decoded bit and if the bit is a marked decoded bit, for every state, selecting (84, ,85) both a most probable state sequence ending in that state from the new plurality of state sequences and a corresponding updated sum of error coefficients according to said predetermined bit, thereby discounting, at a bit location in the encoded signal corresponding to the marked decoded bit, any state inconsistent with the marked decoded bit; if the bit is not a marked decoded bit, for every state, comparing (83) said updated sums of error coefficients and selecting an updated sum of error coefficients representing a lesser total of said differences between the received encoded symbols and the expected symbols and selecting a corresponding most probable state sequence ending in that state from the new plurality of state sequences; determining a best current state for the bit in the original signal by one of comparing the updated sums of error coefficients of the most probable state sequences for every state and choosing a state arbitrarily; and thereby determining, by tracing back from the best current state, a most probable earliest transition and earliest state that occurred a predetermined plurality of symbols previously, and outputting a bit most probably equal to the bit in the original signal to form a second Viterbi decoded signal;
g) de-interleaving the second Viterbi decoded signal with second de-interleaver means (33) to form a second de-interleaved signal; and
h) block decoding the second de-interleaved signal with second block decoder means (34) to form a decoded output signal.

2. A method as claimed in claim 1, wherein the method includes further iterative steps after step h) of using further delay means (41) further to delay the delayed encoded signal and repeating at least once steps e) to h) to decode the further delayed encoded signal using known bits from the decoded output signal from step h).

3. A method as claimed in claims 1 or 2, wherein the step of decoding the delayed encoded signal comprises determining a Viterbi state trellis corresponding to a convolutional code used to encode the encoded signal, adding and comparing error coefficients of transition paths of the delayed encoded signal through the Viterbi state trellis to select a most probable transition path, while ignoring at a location in the delayed encoded signal corresponding to the marked decoded bits in the marked decoded signal any state in the Viterbi state trellis not consistent with the marked decoded bits and any transition path passing through such a state, thereby determining, from the most probable transition path, a second Viterbi decoded signal having a least number of errors taking into account the marked decoded bits in the marked decoded signal.

4. A method as claimed in any of the preceding claims wherein the step of block decoding comprises Reed-Solomon block decoding.

5. A method as claimed in any of the preceding claims, wherein the original signal has at least one predetermined bit at a predetermined bit location, and the step of decoding the encoded signal with the first Viterbi decoder means comprises:
a) for each received encoded symbol of the encoded signal representative of a bit in the original signal, adding, for each possible current state, error coefficients representative of differences between the received encoded symbol, representative of a transition from a previous state of the convolutional encoder to a current state, and expected symbols corresponding to predetermined permitted transitions from previous states to the current state, to a sum of such error coefficients for said previous states to form updated sums of such error coefficients for each of a new plurality of state sequences for all possible states;
b) if the bit is a predetermined bit, for every state, selecting both a most probable state sequence ending in that state from the new plurality of state sequences and a corresponding updated sum of error coefficients according to said predetermined bit, thereby discounting, at the bit location in the encoded signal corresponding to the predetermined bit location in the original signal, any state inconsistent with the predetermined bit at the predetermined bit location;
c) if the bit is not a predetermined bit, for every state, comparing said updated sums of error coefficients and selecting an updated sum of error coefficients representing a lesser total of said differences between the received encoded symbols and the expected symbols and selecting a corresponding most probable state sequence ending in that state from the new plurality of state sequences;
d) determining a best current state for the bit in the original signal by either comparing the updated sums of error coefficients of the most probable state sequences for every state or choosing a state arbitrarily; and
e) thereby determining, by tracing back from the best current state, a most probable earliest transition and earliest state that occurred a predetermined plurality of symbols previously, and thereby finding and outputting a bit most probably equal to the bit in the original signal.

6. A method as claimed in claim 5, wherein the step of adding sums of error coefficients comprises the steps of:
a) determining a Viterbi state trellis corresponding to a convolutional code used to encode the encoded signal; and
b) adding sums of error coefficients of transition paths of the encoded signal through the Viterbi state trellis to select a most probable transition path.

7. A method as claimed in claims 5 or 6, wherein the at least one predetermined bit at a predetermined bit location is a synchronisation bit.

8. A decoder for decoding a concatenated convolutional encoded and block encoded signal derived from an original signal, comprising:
receiving means for receiving the encoded signal;
applying means connected to the receiving means and to first Viterbi decoder means (22) and first delay means (31) for applying the encoded signal thereto;
first de-interleaver means (23) connected to the first Viterbi decoder means for de-interleaving a decoded signal received from the first Viterbi decoder means to form a first de-interleaved signal;
first block decoder means (24) connected to the first de-interleaver means for block decoding the first de-interleaved signal, identifying correctly decoded blocks and marking decoded bits identified as belonging to the correctly decoded blocks to form a marked decoded signal (25);
first interleaver means (26) connected to the first block decoder means for interleaving the marked decoded signal;
second Viterbi decoder means (32) connected to the first interleaver means and to the first delay means for decoding a delayed encoded signal received from the first delay means using the marked decoded signal by: for each received encoded symbol of the delayed encoded signal representative of a bit in the original signal, adding (81, 82), for each possible current state of a convolutional encoder used to encode the convolutional encoded and block encoded signal, error coefficients representative of differences between the received encoded symbol, representative of a transition from a previous state of the encoder to a current state, and expected symbols corresponding to predetermined permitted transitions from previous states to the current state, to a sum of such error coefficients for said previous states to form updated sums of such error coefficients for each of a new plurality of state sequences for all possible states; if the bit is a marked decoded bit, for every state, selecting (84, 85) both a most probable state sequence ending in that state from the new plurality of state sequences and a corresponding updated sum of error coefficients according to said predetermined bit, thereby discounting, at a bit location in the encoded signal corresponding to the marked decoded bit, any state inconsistent with the marked decoded bit; if the bit is not a marked decoded bit, for every state, comparing (83) said updated sums of error coefficients and selecting an updated sum of error coefficients representing a lesser total of said differences between the received encoded symbols and the expected symbols and selecting a corresponding most probable state sequence ending in that state from the new plurality of state sequences; determining a best current state for the bit in the original signal by one of comparing the updated sums of error coefficients of the most probable state sequences for every state and choosing a state arbitrarily; and thereby determining, by tracing back from the best current state, a most probable earliest transition and earliest state that occurred a predetermined plurality of symbols previously, and outputting a bit most probably equal to the bit in the original signal;
second de-interleaver means (33) connected to the second Viterbi decoder means for de-interleaving a signal received from the second Viterbi decoder means to form a second de-interleaved signal;
second block decoder means (34) connected to the second de-interleaver means for block decoding the second de-interleaved signal to form a decoded output signal; and
transmitting means connected to the second block decoder means for transmitting the decoded output signal.

9. A decoder as claimed in claim 8, comprising second delay means (41), and second interleaver means (36), third Viterbi decoder means (42), third de-interleaver means and third block decoder means (44) for carrying out one or more decoding iterations to decode a further delayed encoded signal from the second delay means using known bits of the decoded output signal from a previous iteration.

10. A decoder as claimed in claims 8 or 9, wherein the second Viterbi decoder means is arranged to determine a Viterbi state trellis corresponding to a convolutional code used to encode the encoded signal, to add and compare error coefficients of transition paths of the delayed encoded signal through the Viterbi state trellis to select a most probable transition path, while ignoring at a location in the delayed encoded signal corresponding to the marked decoded bits in the marked decoded signal any state in the Viterbi state trellis not consistent with the marked decoded bits and any transition path passing through such a state, thereby to determine, from the most probable transition path, a second Viterbi decoded signal having a least number of errors taking into account the marked decoded bits in the marked decoded signal.

11. A decoder as claimed in any of claims 8 to 10 wherein each of the block decoding means comprises Reed-Solomon block decoding means.

12. A decoder as claimed in any of claims 8 to 11, for decoding an encoded signal having at least one predetermined bit at a predetermined bit location, wherein the first Viterbi decoder means comprises:
summing means for adding for each received encoded symbol representative of a bit in the original signal, and for each possible current state, error coefficients representative of differences between the received encoded symbol, supposedly representative of a transition from a previous state of the encoder to a current state, and expected symbols corresponding to predetermined alternative permitted transitions from previous states to the current state, to a sum of such error coefficients for said previous states to form updated sums of such error coefficients for each of a new plurality of state sequences for all possible states,
comparing and selecting means for: if the bit is a predetermined bit, for every state, selecting both a most probable state sequence ending in that state from the new plurality of state sequences and a corresponding updated sum of error coefficients according to said predetermined bit, thereby discounting, at a bit location in the encoded signal corresponding to the predetermined bit location in the original signal, any state inconsistent with the predetermined bit at the predetermined bit location; and, if the bit is not a predetermined bit, for every state comparing said updated sums of error coefficients and selecting an updated sum of error coefficients representing a lesser total of said differences between the received encoded symbols and the expected symbols and selecting a corresponding most probable state sequence ending in that state from the new plurality of state sequences; and
processing means for determining a best current state for the bit in the original signal by either comparing the updated sums of error coefficients of the most probable state sequences for every state or choosing a state arbitrarily; and thereby determining, by tracing back from the best current state, a most probable earliest transition and earliest state that occurred a predetermined plurality of symbols previously, and thereby finding a bit most probably equal to the bit in the original signal.

13. A decoder as claimed in claim 12, wherein the first Viterbi decoder means is arranged to:
determine a Viterbi state trellis corresponding to a convolutional code used to encode the encoded signal; and
add sums of error coefficients of transition paths of the encoded signal through the Viterbi state trellis to select a most probable transition path.

14. A decoder as claimed in claims 12 or 13, wherein the at least one predetermined bit at a predetermined bit location is a synchronisation bit.

15. A computer program comprising code means for performing all the steps of the method of any of claims 1 to 7 when the program is run on one or more computers.
